Europäisches Patentamt

European Patent Office

Office européen des brevets

(11) Publication number: **0 180 339**
**A2**

(12) **EUROPEAN PATENT APPLICATION**

(21) Application number: **85307038.1**

(22) Date of filing: **02.10.85**

(51) Int. Cl.⁴: **H 03 D 5/00, H 04 B 1/40,**
**H 03 D 1/22, H 03 C 5/00,**
**H 03 D 3/00**

---

(30) Priority: **25.10.84 GB 8426953**

(43) Date of publication of application: **07.05.86**
**Bulletin 86/19**

(84) Designated Contracting States: **AT BE CH DE FR IT LI LU NL SE**

(71) Applicant: **STC plc, 190 Strand, London, WC2R 1DU (GB)**

(72) Inventor: **Masterton, John, 43 Collins Cross, Bishops Stortford Hertfordshire (GB)**
Inventor: **Ramsdale, Peter Alan, Bishops Cottage Widdington, Saffron Walden Essex (GB)**

(74) Representative: **Capsey, Sydney Ross et al, Standard Telephones and Cables Patent Department Edinburgh Way, Harlow Essex CM20 2SH (GB)**

---

(54) **A multi-mode radio transceiver.**

(57) A multi-mode radio transceiver comprising a sequence of bi-directional circuit modules including a radio frequency input/output amplifier module (1), a radio frequency/baseband I and Q quadrature channel conversion module (2), an analogue/ digital conversion module (3), a digital signal processor (4, 5), and a digital signal input/output interface (6), with a control means (7) whereby for transmission a radio frequency signal is formed from analogue quadrature I and Q channel components of a digitised signal at baseband and translated to the radio tranmission frequency and for reception the radio frequency signals are transformed into I and Q quadrature analogue components at baseband and subsequently digitised.

EP 0 180 339 A2

ACTORUM AG

# A MULTI-MODE RADIO TRANSCEIVER

This invention relates to a multi-mode radio transceiver having the capability to receive and transmit signals of amplitude, frequency, phase or mixed modulation formats.

The development of radio circuits using the so-called "zero I.F." or "direct conversion" principles has enabled radio receivers to be constructed using integrated solid state circuitry, with virtually the entire r.f. portion of the receiver being incorporated in a single chip. British patent 1530602 (I.A.W. Vance-1) discloses a radio receiver structure, suitable for implementation as an integrated circuit, in which the received r.f. signals are mixed with a local oscillator signal at the carrier frequency to produce "in-phase (I)" and "quadrature (Q)" baseband signals. Demodulation can then be performed in a number of ways, one of which is by using a digital signal processor (DSP) in a manner similar to that disclosed in British patent application 8127797 (J.K. Goatcher-2). The filtered analogue quadrature signals are converted to digital signals and processed digitally to reproduce the original modulating signal according to whether the transmission modulation was am, fm or pm. In a variant on the basic direct conversion principle for single sideband modulation the mixing frequency is the side band centre frequency instead of the carrier frequency.

According to the present invention there is provided a multi-mode radio transceiver comprising a sequence of circuit modules characterised in that the modules are each bi-directional and include a radio frequency input/output amplifier module, a radio frequency/baseband I and Q quadrature channel conversion module, an analogue/digital conversion module, a digital signal processor, and a digital signal input/output interface, with a control means whereby for transmission a radio frequency signal is formed from analogue quadrature I and Q channel components of a digitised signal at baseband and translated to the radio transmission frequency and for reception the radio frequency signals are transformed into I and Q quadrature analogue components at baseband and subsequently digitised.

An important feature in the successful implementation of a radio transceiver of this type is provision for automatic balancing of errors between the quadrature I and Q channels. Various forms of channel imbalance error can be balanced by a system of feedforward and feedback loops in the digital signal processor.

Embodiments of the invention will now be described with reference to the accompanying drawings, in which:

Fig. 1 shows a block schematic diagram of a multi-mode radio transceiver,

Fig. 2 illustrates functional elements of a digital signal processor operating in receive mode,

Fig. 3 illustrates conversion from rectangular to polar coordinates,

Fig. 4 illustrates a demodulation implementation,

Figs. 5-7 illustrate various imbalance error correction arrangements,

Figs. 8-11 illustrate various modulation arrangements.

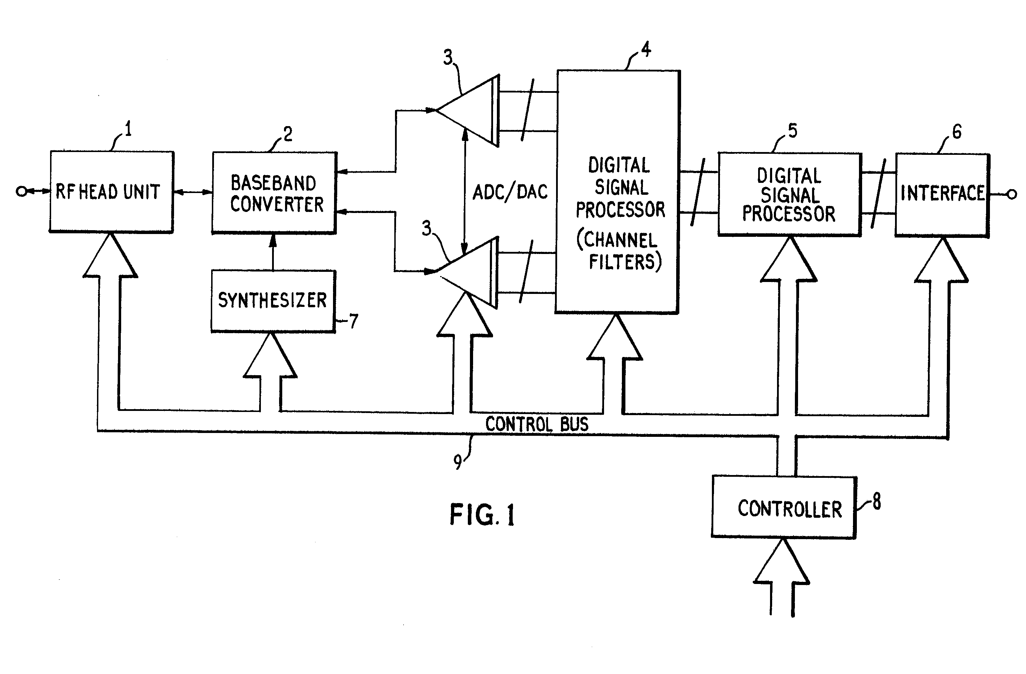

In the block diagram of a multi-mode radio transceiver shown in Fig. 1 there is a sequence of bi-directional circuit modules comprising a radio frequency head unit 1, a baseband converter 2, analogue/digital converters 3, a first digital signal processing stage 4, a second digital signal processing stage 5, and an interface 6. In addition there is a frequency synthesiser 7 and a controller 8 which is linked to the modules via a control bus 9. On reception signals are amplified (optionally) in the RF head unit and presented to the baseband converter. The baseband converter contains two mixers which have either their local oscillator signals or RF input signals at $90^{\circ}$ relative phase shift. The resulting quadrature baseband signals are then applied to the analogue to digital converters (ADCs). Up to this point in the radio the filtering may be minimal, merely protecting the RF circuitry from unwanted signals and preventing aliasing of frequencies by the ADCs. The digitised baseband signals are then passed to the DSPs which implement some or all of the following processes, as appropriate:

i)     Low pass channel filtering
ii)    Balancing of I- and Q- channels
iii)   Demodulation
iv)    Automatic gain control (AGC)

The AGC can be used to modify the gain of the RF head unit and baseband converter and internally within the DSP to adjust the digital samples.

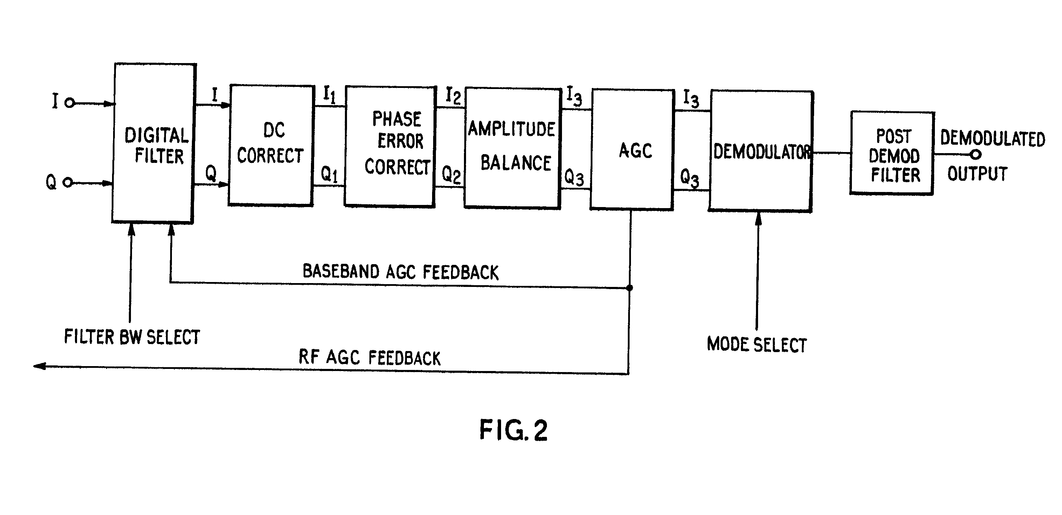

In the functional breakdown of the DSPs shown in Fig. 2, for the receive mode, the incoming I & Q quadrature channel signals are applied first to a digital filter 10. The filtered signals are then DC offset corrected (11), phase error corrected (12) and amplitude balanced (13). An automatic gain control (AGC) 14 is then applied before demodulation (15) is effected, e.g.

- 4 -

in the manner disclosed in British patent application 8127797. Finally the demodulated signals are passed through a post-demodulation filter 16. Note that the AGC can be applied via feedback circuits, e.g. to either the digital filter 10 or possibly to the r.f. head unit 1. AGC can also be applied after the demodulation process, using a feed forward gain control loop. This is particularly useful when the AM demodulator according to BPA 8127797 is used. Since demodulation is a software controlled digital process the choice of demodulation mode is effected by means of a mode programme selection.

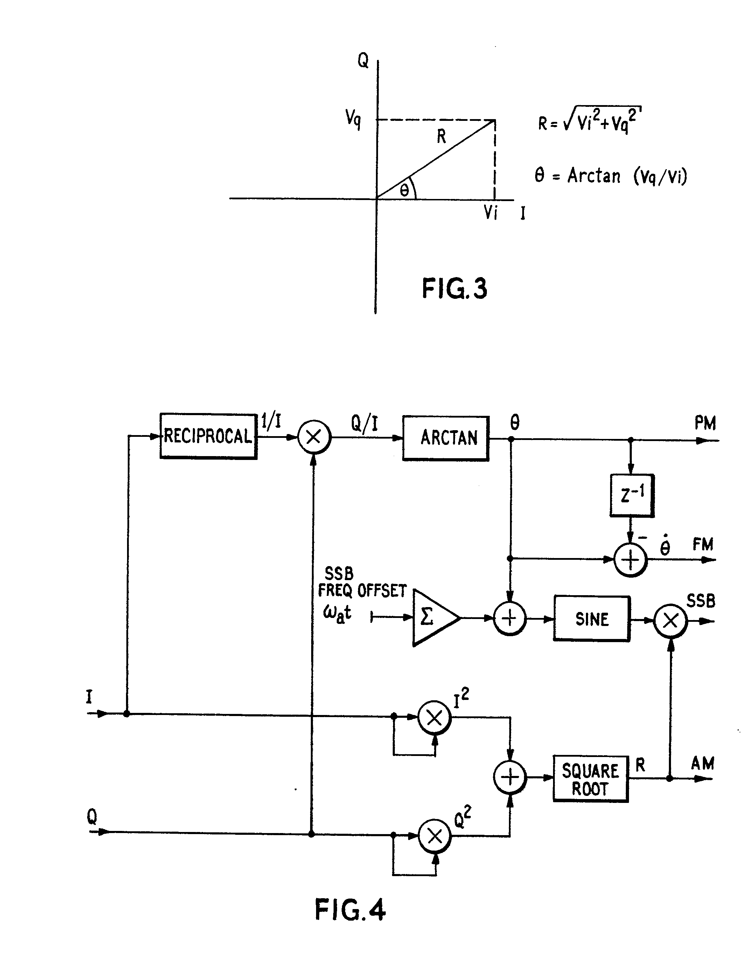

To demodulate the signals from the I- and Q- channels, a conversion from rectangular to polar co-ordinates is required as indicated in Figure 3. The particular modulation format is then decoded by using the amplitude (R), phase ($\theta$) or rate of change of phase ($\dot{\theta}$) information. British patent application 8127797 described a method for achieving this I-, Q-, to R, $\theta$ transformation. An alternative realisation is shown in Figure 4. This scheme has the advantage that the amplitude is found independently of phase. Thus R is not affected by phase errors and if only AM reception is required, then the demodulator can be simplified considerably. To realise either this scheme or that of application 8127797, a process equivalent to division is required. This may be carried out by finding a reciptrocal (from a look-up table) and multiplying, or by finding logarithms (from a look-up table) and subtracting. For their realisation, the other mathematical operations shown (trigonometric identities, square roots, etc.) may be found either from look-up tables or from dedicated function modules. Automatic balancing of the I- and Q- channels is necessary for satisfactory demodulation in a practical system. The correction signals can be derived by comparing long term averages of the two channels. The DC offset, departures from quadrature phasing and differences in channel gains should all be corrected.  Balance can be achieved by:
i)          Feedforward of exact error correction signal
ii)         Feedback of exact error correction signal
iii)        Feedback of steps based on direction of error
iv)         Feedback of random steps (or perturbations to
            minimise error signal)
Any form may be used for each correction and the
corrections can be applied serially or in nested loops.

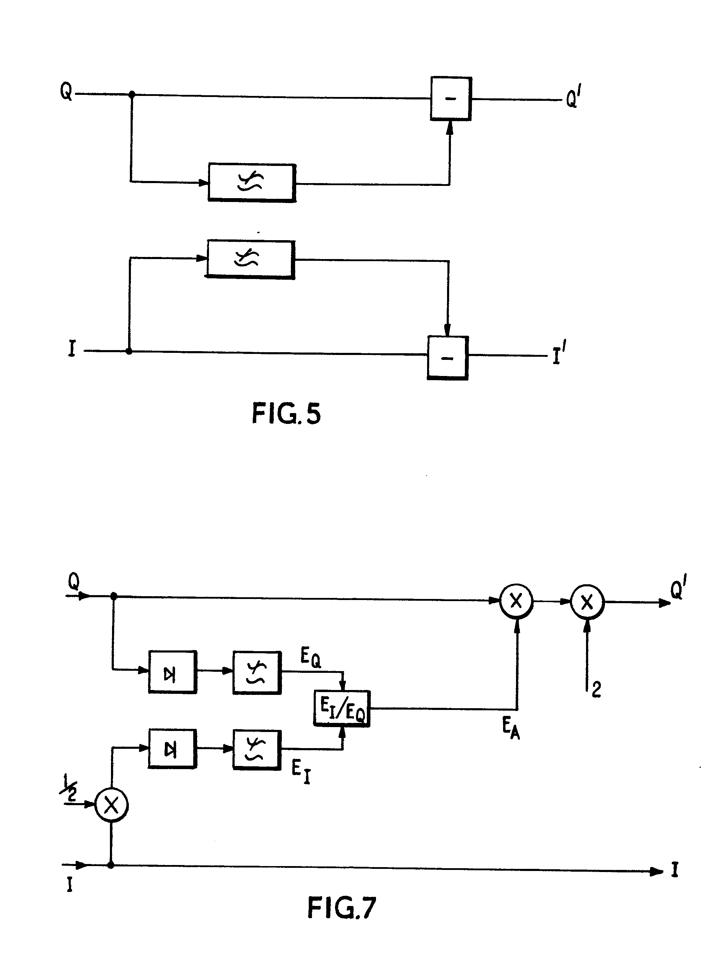

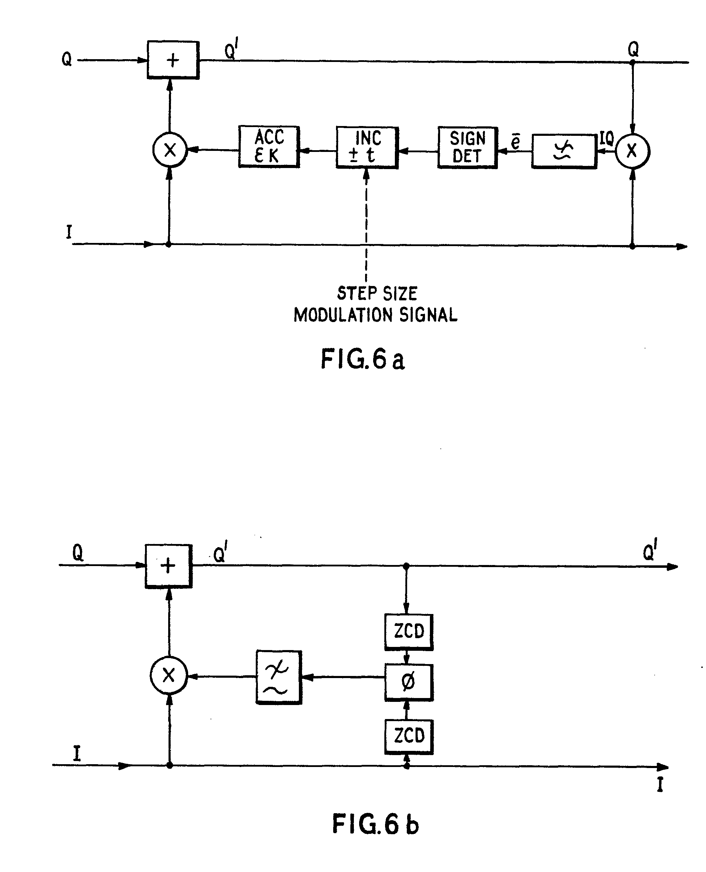

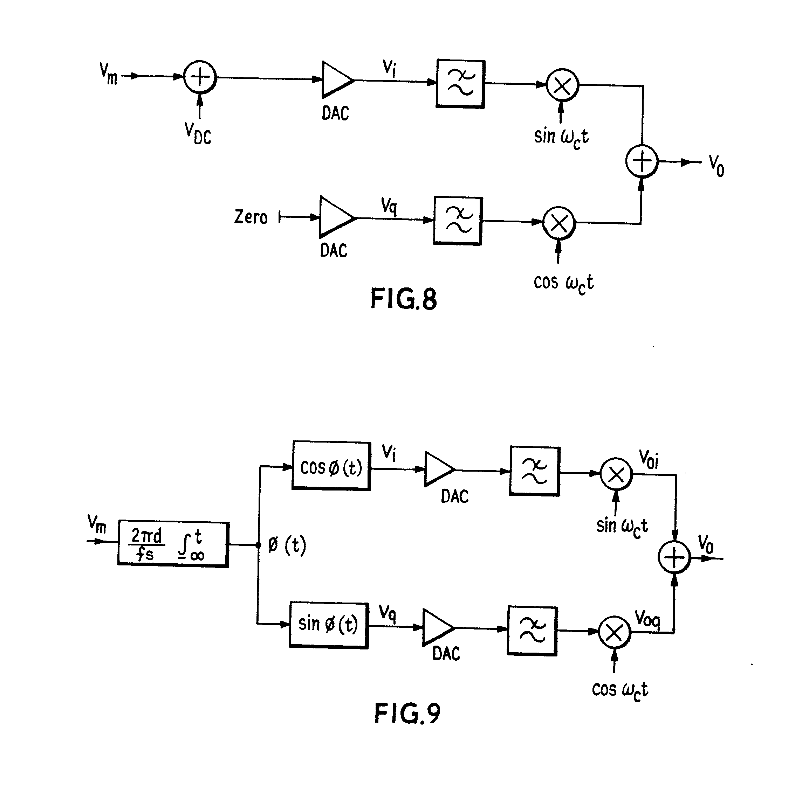

A possible overall balance chain was shown within Figure 2.  Possible detailed implementations of each balance are shown in Figures 5, 6 and 7.  For DC offset, long term averaging removes all AC components and DC correction terms can be added or subtracted, as shown in Figure 5.  In the phase balance scheme of Figure 6, the long term average of the product of the two channels is proportional to the phase imbalance error.  Further mathematical operations on channel signals are required to find this error exactly.  However, by using the sign of this error, positive or negative going steps can be generated.  By applying these steps in a negative feedback loop, the channels move to a phase balance. With this scheme, a further measurement of the error magnitude (either exact or approximate), can provide a step size modulation signal giving large steps for rapid correction of big errors and small steps to minimise quantisation errors when balance is achieved.  An alternative phase balance scheme is shown in 6(b).  In this method, zero crossings in each channel are compared by a phase detector whose stable (zero) output occurs when there is a 90$^{\circ}$ phase difference between inputs. The filtered output from this detector can be directly applied as a correction signal, as shown.  The zero crossings may be determined by zero-crossing detectors, or simple amplitude limiters may be used.  In some cases it may be necessary to apply a weighting or scaling factor to the correction signal before it is used.  The amplitude balance scheme of Figure 7 feeds an exact correction signal forward. The long term averages of rectified channel signals are divided to produce the correction factor. By halving the I-channel signal, the correction factor becomes approximately 1/2. Restricting the result of the $E_I/E_Q$ division to fractional positive numbers considerably simplifies the realisation of this loop by a digital signal processor.

Alternatively, the channel imbalances need not be considered specifically as offset, phase and amplitude (or gain) terms but as any error set of the correct order. A long term correlation of the two channel signals will mathematically yield a correction signal of appropriate order. This can be applied by a feedback or a feedforward technique. For transmission the modules of Figure 1 are used in the reverse direction to reception. The interface provides a digital signal from which the DSPs generate baseband I- and Q-channels. These signals are converted into analogue form by the DACs. The mixers of the baseband converter move these signals to RF by local oscillators at $90^O$ relative phase shift (or with $90^O$ applied to one signal path). The addition of these two signals produces the required RF signal which is amplified (optionally) in the RF head unit.

Possible arrangements for generating amplitude, frequency, phase and SSB modulation are shown in Figures 8, 9, 10 and 11 respectively. For AM (Figure 8), only one channel is required and the other is held at zero. A DC offset is added to the digital message signal and the depth of modulation is determined by their relative levels.

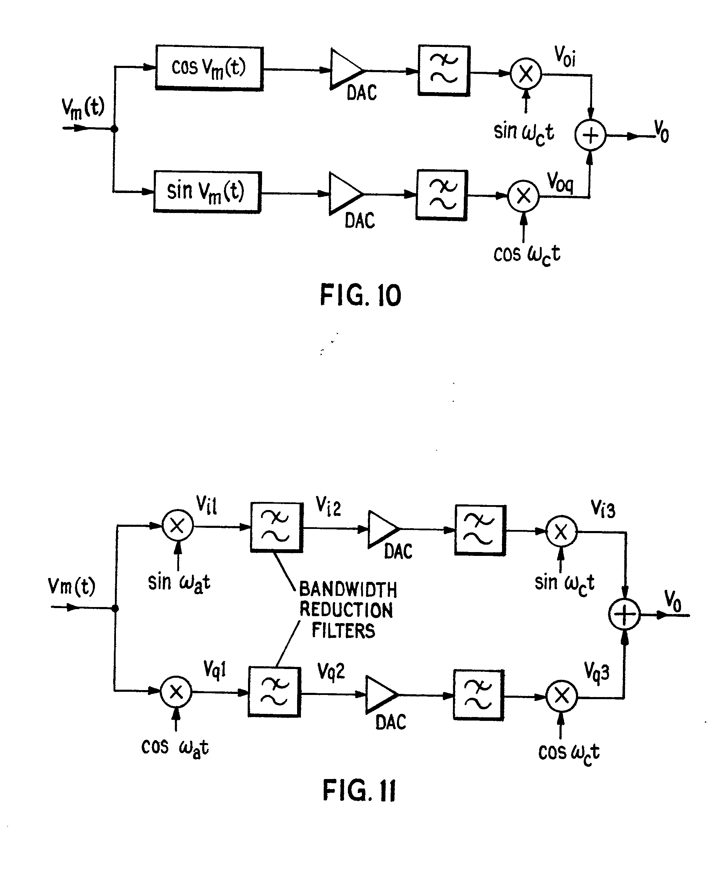

After the DAC the AM signal is converted to RF. In the FM arrangement of Figure 9, the message signal is integrated to give phase values. The quadrature channel signals are found from sine and cosine look up tables. After the DACs, the signals are mixed with quadrature carrier signals and summed to produce the correct FM spectrum. For phase modulation (Figure 10) the same steps as FM are required except that the digitised message signal is used directly as the phase value for the sine and cosine look up tables. In Figure 11, SSB is generated by the Weaver method which is based on quadrature channel cancellations. Thus a complete set of modulation forms can be realised from the same basic architecture consisting of I- and Q-channel DSP baseband generators followed by quadrature baseband to RF mixers.

For its successful realisation, good balance is required between the I- and Q-channels. Balance corrections may be derived from a receiving measurement to estimate the imbalance on transmission (assuming reciprocity) or by feedback or feedforward loops based on the baseband converter output.

CLAIMS:-

1.      A multi-mode radio transceiver comprising a sequence of circuit modules characterised in that the modules are each bi-directional and include a radio frequency input/output amplifier module, a radio frequency/baseband I and Q quadrature channel conversion module, an analogue/digital conversion module, a digital signal processor, and a digital signal input/output interface, with a control means whereby for transmission a radio frequency signal is formed from analogue quadrature I and Q channel components of a digitised signal at baseband and translated to the radio transmission frequency and for reception the radio frequency signals are transformed into I and Q quadrature analogue components at baseband and subsequently digitised.

2.      A multi-mode radio transceiver according to claim 1 characterised in that the digital signal processor module includes digital filtering means for the I and Q quadrature components and means for balancing the signals in the I and Q channels.

3.      A multi-mode radio transceiver according to claim 2 characterised in that the balance means includes means for long term averaging of the signals to remove AC components of the I and Q signals respectively to derive correction terms and means for applying said correction terms in a feedforward loop to the I and Q channels.

4.      A multi-mode radio transceiver according to claim 2 characterised in that the balance means includes means for deriving a long term average of the product of the I & Q channels, determining the sign of the phase imbalance error signal proportional to the product, means for generating corrections terms according to the sign and means for applying said correction terms in a feedback loop to phase balance the I & Q channels.

5.      A multi-mode radio transceiver according to claim 2 characterised in that the balance means includes respective zero crossing detector means for the I and Q channels, phase comparison means to which the zero crossing detector outputs are applied, means for filtering the phase comparison output to derive a correction signal and means for applying said correction signal in a feedback loop to phase balance the I and Q channels.

6. A multi-mode radio transceiver according to claim 2 characterised in that the balance means includes means for rectifying separately the I & Q signals, means for deriving separately long term averages for the rectified I & Q signals, means for dividing the long term average of one channel by the long term average of the other channel to produce an amplitude balance correction factor and means for applying said correction factor in a feedforward loop to the signals in the other channel.

7. A multi-mode radio transceiver substantially as described with reference to the accompanying drawings.

FIG. 1

FIG. 2

0180339

0180339

$$R = \sqrt{V_i^2 + V_q^2}$$

$$\theta = \text{Arctan} \ (V_q/V_i)$$

**FIG.3**

**FIG.4**

FIG.5

FIG.7

5/7  0180339

FIG.6a

STEP SIZE
MODULATION SIGNAL

FIG.6b

$V_m \rightarrow$ $\oplus$ $\rightarrow$ DAC $\rightarrow V_i$ $\approx$ $\rightarrow$ $\otimes$ $\rightarrow$

$V_{DC}$

$\sin \omega_c t$

$\oplus \rightarrow V_0$

Zero $\vdash \rightarrow$ DAC $\rightarrow V_q$ $\approx$ $\rightarrow$ $\otimes$

$\cos \omega_c t$

**FIG.8**

$V_m \rightarrow$ $\dfrac{2\pi d}{fs} \displaystyle\int_{-\infty}^{t}$ $\rightarrow \emptyset(t)$

$\cos \emptyset(t) \rightarrow V_i \rightarrow$ DAC $\rightarrow \approx \rightarrow \otimes \rightarrow V_{0i}$

$\sin \omega_c t$

$\oplus \rightarrow V_0$

$\sin \emptyset(t) \rightarrow V_q \rightarrow$ DAC $\rightarrow \approx \rightarrow \otimes \rightarrow V_{0q}$

$\cos \omega_c t$

**FIG.9**

**FIG. 10**

**FIG. 11**